(19) Europäisches Patentamt / European Patent Office / Office européen des brevets

(11) **EP 1 860 446 B1**

(12) **FASCICULE DE BREVET EUROPEEN**

(45) Date de publication et mention
de la délivrance du brevet:
**31.10.2018 Bulletin 2018/44**

(51) Int Cl.:
***G01R 31/26*** *(2014.01)* ***G01K 7/01*** *(2006.01)*

(21) Numéro de dépôt: **07290636.5**

(22) Date de dépôt: **16.05.2007**

(54) **Procédé et dispositif de mesure de température de jonction d'un composant électronique.**

Verfahren und Vorrichtung zur Messung der Sperrschichttemperatur eines elektronischen Bauteils

Method and device for measuring the temperature of a junction in an electronic component.

(84) Etats contractants désignés:
**CH DE FR GB LI**

(30) Priorité: **23.05.2006 FR 0604628**

(43) Date de publication de la demande:
**28.11.2007 Bulletin 2007/48**

(73) Titulaire: **GE Energy Power Conversion France
SAS
91300 Massy (FR)**

(72) Inventeur: **Gollentz, Bernard
68360 Soultz (FR)**

(74) Mandataire: **Serjeants LLP
Dock
75 Exploration Drive
Leicester, LE4 5NU (GB)**

(56) Documents cités:
**US-A- 3 102 425 US-A- 4 300 048
US-A1- 2004 184 510**

- **RAHIMO M T ET AL: "Test and characterisation
of modern fast -recovery diodes for high speed
switching applications" POWER ELECTRONICS
AND VARIABLE SPEED DRIVES, 2000. EIGHTH
INTERNATIONAL CONFERENCE ON (IEE CONF.
PUBL. NO. 475) 18-19 SEPTEMBER 2000,
PISCATAWAY, NJ, USA,IEEE, 18 septembre 2000
(2000-09-18), pages 103-108, XP010525808 ISBN:
0-85296-729-2**

EP 1 860 446 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

Printed by Jouve, 75001 PARIS (FR)

**Description**

La présente invention concerne un procédé de mesure de la température de jonction d'un composant électronique à semi-conducteurs dont la conduction est assurée par apport permanent de porteurs, du type comportant une étape de mesure d'une quantité électrique sur le composant lors d'une phase déterminée de fonctionnement du composant et une étape de détermination de la température de jonction du composant à partir de la quantité électrique mesurée.

Pour de nombreuses applications d'électronique, et notamment d'électronique de puissance, il est nécessaire de connaître, pour la conception des circuits, ou pour des contrôles du circuit en continu, la température de jonction de certains organes de commutation à semi-conducteur ou de diodes.

A cet effet, il est connu de mesurer la tension aux bornes de la jonction à l'état passant du composant. Cette tension, mesurée entre les deux bornes de la diode, ou entre le collecteur et l'émetteur d'un transistor, est utilisée pour déterminer la température de la jonction, celle-ci étant une fonction de la tension mesurée.

Dans la mesure où la tension à l'état passant du composant est très faible comparé à la tension bloquée, ce procédé de mesure est pratiquement impossible à mettre en oeuvre sur un équipement réel.

On connaît également par les documents US-A 2004/184510 et US-A-3102425, des procédés de mesure de la température d'un composant électronique qui utilisent le courant de fuite d'une jonction ("off leak current" ou "reverse current"). Ce courant de fuite est le courant de régime permanent d'une jonction polarisée en inverse.

L'invention a pour but de proposer un procédé de mesure de la température de jonction alternatif qui soit plus précis et mesurable sur un équipement en fonctionnement normal.

A cet effet, l'invention a pour objet un procédé de mesure du type précité, caractérisé en ce que le composant électronique à semi-conducteurs est un thyristor GTO (Gate turn-off) ou un transistor IGBT, et en ce que ladite quantité électrique est représentative de la quantité de charge ($Q_{tail}$) évacuée par le composant par le courant de queue circulant dans le composant électronique à semi-conducteurs lors du blocage de celui-ci à compter de l'instant déterminé où cesse la phase linéaire de variation de l'intensité du courant.

Suivant des modes particuliers de réalisation, le procédé prévoit la mise en oeuvre de l'une ou plusieurs des caractéristiques suivantes :

-    l'étape de détermination de la température de jonction comporte une étape de mise en oeuvre d'une fonction caractéristique du composant préalablement établie donnant la température de jonction en fonction de la quantité de charge mesuré ;
-    il comporte une étape préalable d'établissement de la fonction caractéristique du composant par mise en oeuvre d'une série de tests successifs pour différentes températures imposées au composant, chaque test incluant la mesure de la quantité électrique pour la température considérée du test et l'établissement de ladite fonction caractéristique.

On observera que la charge évacuée par le courant de queue du composant est sans rapport avec le courant de fuite. Elle constitue en effet un résidu de charges qui ont une durée de vie limitée fonction de la température mais qui, à l'état passant, sont renouvelées par le courant qui passe. Lors du blocage de la jonction, c'est-à-dire en régime transitoire, ces charges sont évacuées après une phase de décroissance linéaire du courant.

L'invention sera mieux comprise à la lecture de la description qui va suivre, donnée uniquement à titre d'exemple et faite en se référant aux dessins, sur lesquels :

-    la figure 1 est une vue schématique d'un circuit électrique incorporant un transistor ;
-    la figure 2 est un ensemble de courbes illustrant les tensions et intensités dans le transistor lors d'une phase de blocage ;
-    la figure 3 est une courbe illustrant la température de jonction d'un transistor en fonction de la quantité de charges mesurée ;
-    la figure 4 est une vue schématique d'une diode ; et
-    la figure 5 est une courbe illustrant les caractéristiques électriques de la diode de la figure 4.

Le procédé selon l'invention qui va être décrit ici est destiné à être appliqué avec des composants électroniques à semi-conducteurs dont la conduction est assurée par apport permanent de porteurs, la conduction n'étant assurée que lorsque de tels porteurs sont continûment apportés alors que l'état bloqué est obtenu en l'absence de fourniture de tels porteurs.

Ainsi, le composant électronique est par exemple un transistor bipolaire de puissance ou un transistor de type IGBT ou encore une diode.

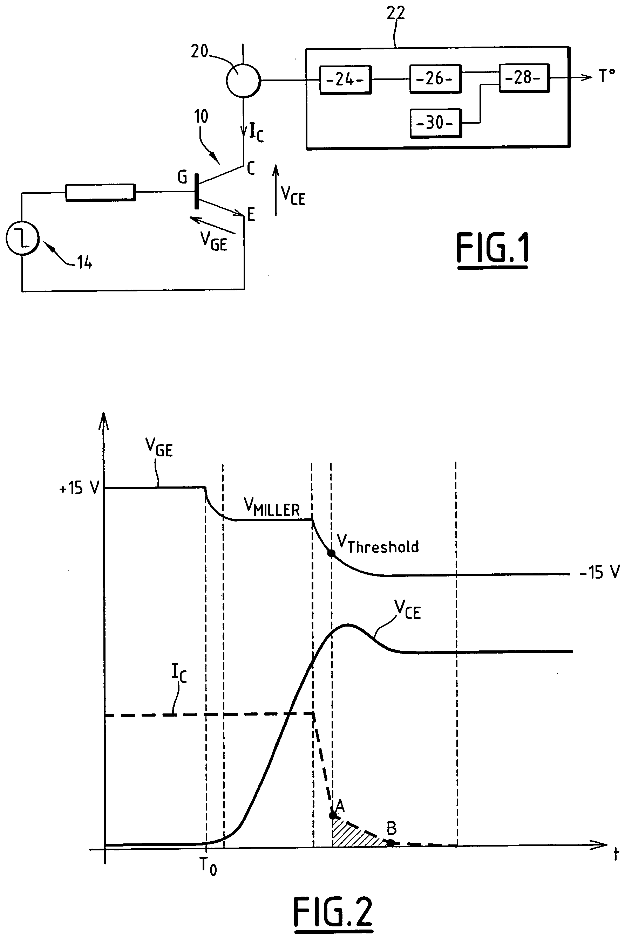

La figure 1 représente un tel transistor 10 dans lequel la grille G est reliée à une générateur de tension 14 propre à fournir un échelon, le générateur de tension étant appliqué entre la grille G et l'émetteur E du transistor. Par convention, on suppose que le transistor 10 est traversé du collecteur C vers l'émetteur E par un courant $I_c$, la tension émetteur-collecteur étant notée $V_{CE}$ et la tension émetteur-grille étant notée $V_{GE}$.

Le générateur de tension 14 est propre à appliquer un échelon de tension, par exemple de + 15 volts à - 15 volts, la tension de + 15 volts appliquée à la grille G assurant la conduction du transistor 10 alors que la tension de -15 volts assurant le blocage du transistor.

Comme illustré sur la figure 2, lors du passage de la tension d'alimentation de + 15 volts à - 15 volts à l'instant $T_o$, la tension émetteur-grille $V_{GE}$ chute d'abord de + 15 volts à la tension de Miller V$_{Miller}$. Pendant cette phase où la tension V$_{GE}$ est égale à la tension de Miller, la tension V$_{CE}$ entre l'émetteur E et le collecteur C augmente de manière sensiblement linéaire. Pendant la montée de la tension V$_{CE}$, l'intensité I$_c$ traversant le transistor 10 reste constante. La tension V$_{GE}$ chute alors de la tension de Miller à une tension de - 15 volts. Pendant la première phase, allant jusqu'à une tension de seuil couramment notée V$_{threshold}$ du transistor, l'intensité I$_c$ décroît de manière linéaire jusqu'au point A de changement de pente.

Lorsque la tension V$_{GE}$ atteint la tension V$_{threshold}$, le composant est théoriquement bloqué. Toutefois, le courant I$_c$ décroît encore depuis le point A de manière plus lente pour constituer un courant de queue jusqu'à s'annuler effectivement au point B. Ainsi, le courant de queue est défini à compter de l'instant où la tension V$_{GE}$ grille émetteur est inférieure à la tension V$_{threshold}$.

Comme connu en soi, on constate pour la tension V$_{thresold}$ caractéristique du transistor correspond à un point A de modification de la dérivée de l'intensité I$_c$.

Selon le procédé objet de l'invention, la charge notée Q$_{tail}$ correspondant à la quantité de charges résultant du courant de queue absorbé par le transistor 10 est déterminée. Cette quantité est représentée hachurée sur la figure 2. En pratique, $Q_{tail} = \int_A^B I_c dt$ .

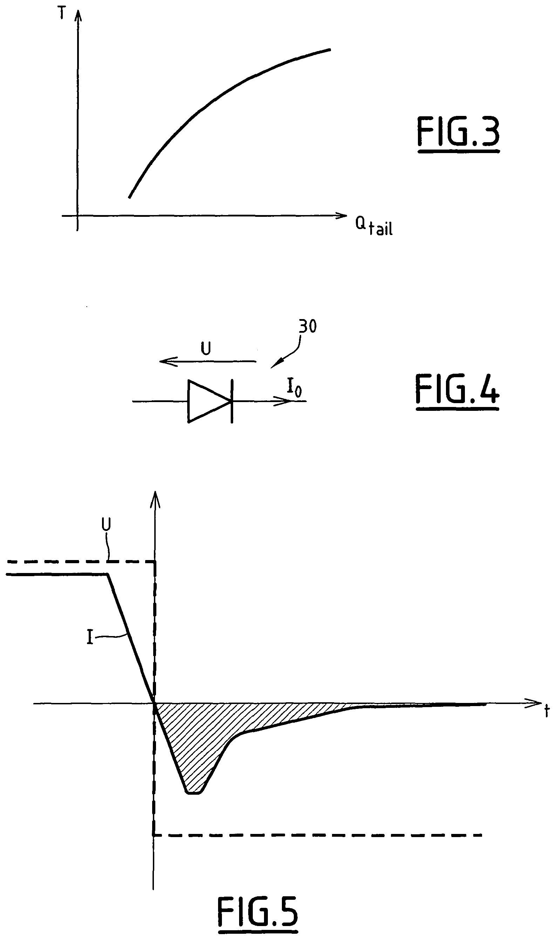

Il a été constaté, comme illustré sur la figure 3, que la température de jonction du composant est fonction de la quantité de charge Q$_{tail}$ résultant du courant de queue telle que mesuré.

Ainsi, selon l'invention, la température de jonction notée T est déterminée à partir d'une fonction caractéristique du composant 10 préalablement établie telle qu'illustrée sur la figure 3 permettant d'exprimer la température de jonction en fonction de la quantité de charge résultant du courant de queue mesurée.

La courbe représentative de la fonction caractéristique est établie préalablement à la mesure de la température à partir d'une série de tests sur un composant électronique en cause.

Pour chaque test, le composant est maintenu dans une étuve où règne une température contrôlée. Pour cette température donnée, une unique phase de blocage est appliquée au composant et la quantité de charges Q$_{tail}$ résultant du courant de queue est mesurée. Le test est pratiqué pour une série de températures déterminées, par exemple des températures de 25°C, 50°C, 75°C, 100°C et 125°C.

Dans la mesure où un unique blocage est effectué pour chaque test, il est supposé que le composant ne subit pas d'échauffement résultant de ce blocage et que la température de jonction est celle imposée par l'étuve.

Ainsi, une fonction telle que celle illustrée sur la figure 3 est établie et les valeurs intermédiaires entre les points correspondants aux tests sont extrapolées.

Pour la mise en oeuvre d'un tel procédé de mesure, une sonde de courant 20 est placée en amont du collecteur comme illustré sur la figure 1 ou en aval de l'émetteur. Le courant est mesuré pendant la phase de blocage du transistor. Des moyens 22 d'analyse du courant mesuré sont reliés à la sonde 20. Ils comportent des moyens 24 de détection d'une variation brusque de la dérivée du courant I$_c$ afin de déterminer le point A correspondant au début du courant de queue. Des moyens 26 d'intégration de ce courant de queue par rapport au temps sont propres à assurer la détermination de la quantité de charge Q$_{tail}$. En outre, des moyens 28 de détermination de la température de jonction à partir de la fonction préalablement établie stockée dans une mémoire 30 et de la quantité de charge mesurée permettent d'obtenir la température effective de la jonction.

On conçoit qu'un tel procédé et qu'un tel dispositif sont relativement simples à utiliser et apportent une précision accrue dans la mesure de la température de jonction.

De manière analogue, pour une diode 30 telle qu'illustrée sur la figure 4, et dont la caractéristique est illustrée sur la figure 5, et la température de la jonction de la diode est déduite de la charge de recouvrement notée Q$_{recovery}$ qui est mesurée.

Pour une diode, la charge de recouvrement Q$_{recovery}$ est définie par la partie hachurée illustrée sur la figure 5. Elle est donnée par l'intégrale par rapport au temps du courant inverse circulant au travers de la diode lors du blocage de celle-ci.

Comme dans le mode de réalisation précédent, la fonction caractéristique de la température de jonction de la diode en fonction de la charge de recouvrement Q$_{recovery}$ est établie expérimentalement à partir de plusieurs mesures faites par des températures différentes de la diode. Pour connaître la température de jonction, la charge de recouvrement Q$_{recovery}$ est mesurée par un capteur de courant et la température est déduite à partir de la fonction caractéristique du composant.

Le procédé de mesure est un procédé de mesure de température indirecte, qui ne nécessite pas d'implantation de capteur dans le composant qui pourrait modifier les caractéristiques thermiques du composant et donc fausser la température. De plus, selon les inventeurs, le procédé de mesure est d'une grande précision puisque les porteurs permettant la conduction sont responsables du courant de queue ou de la charge de recouvrement. Ceux-ci résultent de la disparition des porteurs qui ont une durée de vie limitée et qui, lors du blocage, ne sont plus remplacés par de nouveaux porteurs apportés. Or, la durée de vie des porteurs lors du blocage est une fonction de la température de jonction et, en particulier, plus la température est élevée, plus la durée de vie des porteurs est longue.

## Revendications

1. Procédé de mesure de la température de jonction d'un composant électronique à semi-conducteurs (10) dont la conduction est assurée par apport permanent de porteurs, du type comportant :

   - une étape de mesure d'une quantité électrique sur le composant lors d'une phase déterminée de fonctionnement du composant, et
   - une étape de détermination de la température de jonction du composant à partir de la quantité électrique mesurée,

   **caractérisé en ce que** le composant électronique à semi-conducteurs est un thyristor de type Gate turn-off GTO ou un transistor IGBT (10), et **en ce que** la quantité électrique est représentative de la quantité de charge ($Q_{tail}$) évacuée par le composant par le courant de queue circulant dans le composant électronique à semi-conducteurs lors du blocage de celui-ci à compter de l'instant déterminé (A) où cesse la phase linéaire de variation de l'intensité du courant ($I_c$).

2. Procédé de mesure selon la revendication 1, **caractérisé en ce que** l'étape de détermination de la température de jonction comporte une étape de mise en oeuvre d'une fonction caractéristique du composant préalablement établie donnant la température de jonction en fonction de la quantité de charge mesurée.

3. Procédé de mesure selon la revendication 2, **caractérisé en ce qu'**il comporte une étape préalable d'établissement de la fonction caractéristique du composant par mise en oeuvre d'une série de tests successifs pour différentes températures imposées au composant, chaque test incluant la mesure de la quantité électrique pour la température considérée du test et l'établissement de ladite fonction caractéristique.

## Patentansprüche

1. Verfahren zum Messen der Sperrschichttemperatur eines elektronischen Halbleiterbauteils (10), bei dem die Leitung durch permanente Zufuhr von Ladungsträgern sichergestellt ist, des Typs aufweisend:

   - einen Schritt des Messens einer elektrischen Größe an dem Bauteil während einer bestimmten Funktionsphase des Bauteils und
   - einen Schritt der Bestimmung der Sperrschichttemperatur des Bauteils auf Basis der gemessenen elektrischen Größe,

   **dadurch gekennzeichnet, dass** das elektronische Halbleiterbauteil ein Thyristor des Typs Gate-Turn-Off GTO oder ein IGBT-Transistor (10) ist und dadurch, dass die elektronische Größe repräsentativ ist für die Ladungsmenge ($Q_{tail}$), die vom Bauteil während dessen Sperrens durch den durch das elektronische Halbleiterbauteil fließenden Tail-Stroms abgebaut werden muss, von dem bestimmten Zeitpunkt (A) an, zu dem die lineare Phase der Intensitätsänderung des Stromes ($I_c$) endet.

2. Verfahren nach Anspruch 1, **dadurch gekennzeichnet, dass** der Schritt des Bestimmens der Sperrschichttemperatur einen Schritt der Implementierung einer charakteristischen Funktion des Bauteils umfasst, die vorherbestimmt ist und die Sperrschichttemperatur als Funktion der gemessenen Ladungsmenge angibt.

3. Verfahren nach Anspruch 2, **dadurch gekennzeichnet, dass** es einen vorausgehenden Schritt des Bestimmens der charakteristischen Funktion des Bauteils durch das Ausführen einer Reihe von aneinander folgenden Tests bei unterschiedlichen auf das Bauteil aufgebrachten Temperaturen umfasst, wobei jeder Test das Messen der elektrischen Größe für die betrachtete Temperatur des Tests und das Einrichten der charakteristischen Funktion aufweist.

## Claims

1. Method for measuring the junction temperature of an electronic semiconductor component (10) in which conduction is ensured by the permanent supply of carriers, of the type comprising:

   - a step of measuring an electrical quantity on the component during a predetermined operating phase of the component, and
   - a step of determining the junction temperature of the component from the measured electrical quantity,

   **characterised in that** the electronic semiconductor component is a thyristor of the gate turn-off type (GTO) or an IGBT transistor (10), and that the electrical quantity is representative of the charge quantity ($Qt_{ail}$) evacuated by the component via the tail current circulating in the electronic semiconductor component during its blocking, starting from the predetermined instant (A) at which the linear phase of variation of current intensity ($I_c$) stops.

2. Measuring method according to claim 1, **characterised in that** the step of determining the junction temperature comprises a step of performing a predetermined characteristic function of the component giving the junction temperature as a function of the measured quantity of charge.

3. Measuring method according to claim 2, **characterised in that** it comprises a prior step of establishing the characteristic function of the component by performing a series of successive tests for various temperatures imposed on the component, each test including measurement of the electrical quantity for the respective test temperature and establishment of said characteristic function.

FIG.1

FIG.2

FIG.3

FIG.4

FIG.5

**EP 1 860 446 B1**

## RÉFÉRENCES CITÉES DANS LA DESCRIPTION

**Documents brevets cités dans la description**

- US 2004184510 A

- US 3102425 A